Europäisches Patentamt

European Patent Office

Office européen des brevets

(11) Veröffentlichungsnummer: **0 021 020**
A1

## (12) EUROPÄISCHE PATENTANMELDUNG

(21) Anmeldenummer: **80102733.5**

(22) Anmeldetag: **16.05.80**

(51) Int. Cl.³: **H 03 H 11/04**, H 03 H 11/20

(30) Priorität: **07.06.79 DE 2923147**

(43) Veröffentlichungstag der Anmeldung: **07.01.81**
Patentblatt 81/1

(84) Benannte Vertragsstaaten: **BE CH FR GB LI NL SE**

(71) Anmelder: **SIEMENS AKTIENGESELLSCHAFT Berlin und München, Postfach 22 02 61, D-8000 München 22 (DE)**

(72) Erfinder: **Kaufhold, Wolfgang, Dipl.-Ing., Lannersberg 15, D-8520 Erlangen-Tennenlohe (DE)**

(54) **Selektive Filteranordnung hoher Güte.**

(57) Die Erfindung betrifft eine selektive Filteranordnung hoher Güte für einen bestimmten Frequenzbereich, bei der aus dem geregelten Phasenwinkel eine Einflußgröße abgeleitet wird. Zur Ableitung der Einflußgröße aus oberschwingungshaltigen und veränderlichen Meßgrößen werden zwei gleichartige selektive elektronische Filter (F1, F2) in Reihe geschaltet und ihre Ausgänge auf ein Phasenwinkeldifferenzmeßglied (Ph) geführt. Der Ausgang dieses Gliedes wird über einen PI-Regler (Re) auf Abgleichwiderstände in den Filtern gegeben, so daß die frequenzabhängige Phasendifferenz auf den Wert Null geregelt wird. Bei Überschreiten des Regelbereiches erfolgt durch einen Grenzwertmelder (GW) ein Signal, das hierzu von der Summe der Ausgänge beider Filter beaufschlagt wird.

0021020

SIEMENS AKTIENGESELLSCHAFT     Unser Zeichen
Berlin und München             VPA 79 P 3085 EUR

**Selektive Filteranordnung hoher Güte**

Die Erfindung betrifft eine selektive Filteranordnung nach dem Oberbegriff des Patentanspruchs 1.

Die bekannten Filteranordnungen dieser Art arbeiten in zufriedenstellender Weise nur bei oberschwingungsarmen und möglichst konstanten Meßgrößen, andernfalls unzulässige Meßfehler auftreten, da die bekannten Filteranordnungen einen merklichen Phasengang aufweisen.

Um solche Filteranordnungen auch bei veränderlichen und/oder oberschwingungshaltigen Meßgrößen anwenden zu können, hat man durch diskrete Resonanzkreise die Oberschwingungen zu unterdrücken versucht oder gar aus den oberschwingungshaltigen Meßgrößen durch künstliche Drehstromsysteme oberschwingungsfreie nachgeführte Ersatzmeßgrößen gewonnen.

Diese nur beschränkt anwendbaren oder aber sehr aufwendigen Maßnahmen durch einfachere und wirkungsvollere

0021020

unbeschränkt einsatzfähige Maßnahmen zu ersetzen, ist
Aufgabe der Erfindung.

Die Lösung dieser Aufgabe gelingt bei einer selektiven
Filteranordnung der eingangs genannten Art durch die
Maßnahmen nach dem Kennzeichen des Patentanspruchs 1.

Vorteilhafte Ausgestaltungen und Weiterbildung der
Erfindung sind Gegenstand von Unteransprüchen.

Die hierbei verwendeten beiden Filter sind z.B. aus dem
Buch "Halbleiterschaltungstechnik" von Tietze u. Schenk
Springer-Verlag 1971, insbesondere Seite 175 ff. bekannt.

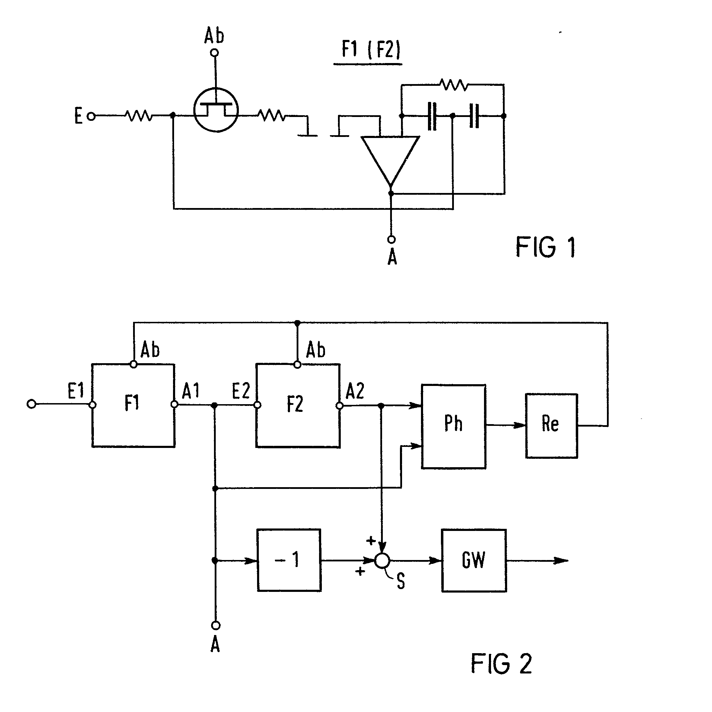

Jedes dieser Filter enthält nach Fig. 1 im Eingangskreis
einen steuerbaren Feldeffekttransistor sowie im Ausgangskreis einen Differenzverstärker mit R-C-Gliedern in dessen Rückführkreis, die mit dem Eingangskreis in Verbindung stehen. Die R-C-Glieder bestimmen die Frequenz des
Filters.

Die beliebig oberschwingungshaltige und gegebenenfalls
veränderliche Meßgröße wird dem Eingang E1 des ersten
Filters F1 zugeführt, dessen Ausgang A1 mit dem Eingang
E2 des zweiten gleichartigen Filters E2 direkt verbunden
ist. An die besagte Verbindung beider Filter ist der
Ausgang A der Filteranordnung angeschlossen, an dem die
Einflußgröße abgenommen wird.

Die Ausgänge A1 und A2 beider Filter F1 und F2 sind mit
den Eingängen eines Phasenwinkeldifferenzmeßgliedes Ph
verbunden, dessen Ausgangsgröße über einen PI-Regler Re
die Feldeffekttransistoren beider Filter bei Ab beeinflußt, so daß für die eingestellte Frequenz der ausreichend selektiven Filter F1, F2 auf die Phasenwinkeldifferenz Null entsprechend den Resonanzbedingungen abgeglichen wird.

Durch.die Reihenschaltung der beiden gleichartigen Filter
werden nämlich zwei oberschwingungsfreie Wechselströme
als Ausgangsgrößen zum Phasenwinkelvergleich geschaffen
und aus deren Differenz eine passende Regelgröße für das
erste Filter F1 gewonnen, wobei durch den Proportionalanteil des Reglers eine ausreichend schnelle und durch
den Integralanteil des Reglers eine hinreichend genaue
Einhaltung der Resonanzbedingungen gewährleistet ist.
Da beide Filter gleichartig sind, ist demnach auch die
Phasenwinkeldifferenz zwischen der dem Eingang E1 zugeführten Meßgröße, die Grund- und Oberschwingungen enthält, und dem am Ausgang A1 und damit am Ausgang A abgenommene Einflußgröße auf Null geregelt.

Bei zu starker Änderung der Amplitude der Meßgröße etwa
auftretende Einschwingvorgänge mit resultierender Überschreitung des Regelbereiches sowie Störungen der Filter
können mit Hilfe eines Grenzwertmelders GW angezeigt
werden, der hierzu mit einem Summierglied S verbunden
ist, auf den die Ausgangsgröße der beiden Filter direkt
bzw. über ein Vorzeichenumkehrglied –1 summierend gegeben werden.

Somit sind auch stark oberschwingungshaltige Meßgrößen
mit verschliffenen Nulldurchgängen sicher auswertbar, so
daß sich die Filteranordnung nach der Erfindung besonders für HGÜ-Steuersätze, insbesondere auf der Wechselrichterseite, bei Netzen mit geringer Kurzschlußleistung
zur Filterung der Synchronisierspannungen eignet. Eine
andere vorteilhafte Anwendung ist bei Meßspannungsfilterung gegeben, um bei der Effektivwertbildung von Oberschwingungen unbeeinflußte Integrationsintervalle zu erhalten. Ebenso sind solche Filteranordnungen vorteilhaft bei Frequenzmessungen durch Spannungsnulldurchgänge
der Grundschwingungen anwendbar.


3 Patentansprüche
2 Figuren

0021020

Patentansprüche

1. Selektive Filteranordnung hoher Güte für einen bestimmten Frequenzbereich, bei der aus dem geregelten
Phasenwinkel zwischen seiner Ausgangs- und seiner als
Meßwert zugeführten Eingangsgröße eine weiter verarbeitbare Einflußgröße abgeleitet wird, d a d u r c h   g e -
k e n n z e i c h n e t ,  daß zwei gleichartige selektive elektronische Filter vorgesehen sind, von denen dem
Eingang des ersten Filters die Meßgröße und dem Eingang
des zweiten Filters die Ausgangsgröße des ersten Filters
zugeführt ist, daß die Ausgangsgrößen beider Filter einem
Phasenwinkeldifferenzmeßglied zugeführt und dessen Phasendifferenz über einen PI-Regler auf in den Eingangskreisen
beider Filter angeordnete variable Widerstände zurückgeführt ist im Sinne einer Regelung der frequenzabhängigen Phasendifferenz auf den Wert Null.

2. Filteranordnung nach Anspruch 1, d a d u r c h
g e k e n n z e i c h n e t , daß die beiden Ausgangsgrößen über eine Vergleichseinrichtung einem Grenzwertmelder zugeführt sind, der bei Überschreiten des Regelbereiches durch überstarke Einschwingvorgänge oder bei
Störungen der Filter eine Ausgangsmeldung ergibt.

3. Filteranordnung nach Anspruch 1, d a d u r c h
g e k e n n z e i c h n e t , daß als variable Widerstände im Eingangskreis der Filter Feldeffekttransistoren dienen.

0021020
79 P 3085    1/1

Ab

F1 (F2)

E

FIG 1

A

FIG 2

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE - A - 1 941 710 (LICENTIA)<br>* Ganzes Dokument * | 1 |
| | US - A - 3 714 588 (G.J. DEBOO et al.)<br>* Figur 2; Spalte 3, Zeilen 4-19; Spalte 6, Zeilen 15-26 * | 1,3 |
| | ELEKTRONIK, Band 27, Nr. 7, Juli 1978<br>MÜNCHEN (DE)<br>K. KRAUS: "Phasenregelkreis steuert Analogfilter", Seiten 101,102.<br>* Ganzes Dokument * | 1,3 |

### KLASSIFIKATION DER ANMELDUNG (Int. Cl.¹)

H 03 H 11/04
H 03 H 11/20

### RECHERCHIERTE SACHGEBIETE (Int. Cl.³)

H 03 H 11/04
        11/12
        11/20
H 03 J  7/04
        7/02
        7/08
H 03 L  7/00
H 03 D  3/22
G 01 R 17/06

### KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 10-09-1980 | COPPIETERS |

EPA form 1503.1  06.78